# EUROPÄISCHE PATENTANMELDUNG

(11) **EP 2 757 862 A2**
(43) Veröffentlichungstag der Anmeldung: **23.07.2014**
(21) Anmeldenummer: 13006009.8
(22) Anmeldetag: 23.12.2013
(51) Int. Cl.: H05K 1/14

(54) **Leiterplattenanordnung**

(30) Priorität: 22.01.2013 DE 102013001006
(71) Anmelder: Baumüller Nürnberg GmbH, 90482 Nürnberg (DE)
(72) Erfinder: Grunert, Rainer, 90480 Nürnberg (DE); Hensel, Uwe, 90411 Nürnberg (DE)
(74) Vertreter: FDST Patentanwälte

(57) **Zusammenfassung**

Die Erfindung betrifft eine Leiterplattenanordnung (22) mit einer Leiterplatte (2), die einen SMD-Bestückplatz (10) zur Anbringung eines eine elektrische Schaltung (20) aufweisenden ersten integrierten Schaltkreises (14) aufweist. Auf den SMD-Bestückplatz (10) ist in SMD-Technik eine die elektrische Schaltung (20) aufweisenden Austauschleiterplatte (26) aufgelötet. Die Erfindung betrifft ferner eine Austauschleiterplatte (26).

## Beschreibung

Die Erfindung betrifft eine Leiterplattenanordnung mit einer in SMD-Technik bestückten Leiterplatte. Die Leiterplattenanordnung ist insbesondere Bestandteil einer Steuerschaltung eines Elektromotors.

Elektrische Schaltungen werden üblicherweise mittels Leiterplatten realisiert. Diese umfassen elektrische Bauteile, wie Kondensatoren, Widerstände und integrierte Schaltkreise (IC), bei denen auf einem einzelnen Halbleitersubstrat eine elektronische Schaltungsanordnung untergebracht ist. Dies führt zu einer Kostenersparnis und Miniaturisierung im Vergleich zu einem Aufbau der Schaltungsanordnung aus einzelnen diskreten Bauteilen. Die elektrischen Bauteile werden meist mittels Oberflächenmontage (SMD-Technik) auf der Leiterplatte angebracht, was sowohl eine Miniaturisierung der Leiterplatte als auch Gewichts- und Kostenvorteile ermöglicht. Hierfür wird in einem ersten Arbeitsschritt Lotpaste an bestimmten Stellen der Leiterplatte angebracht. Hieran anschließend werden die Stellen mit elektrischen Bauteilen bestückt und in einem weiteren Arbeitsschritt die Lotpaste zur Erstellung einer elektrischen Verbindung zwischen der Leiterplatte und dem jeweiligen elektrischen Bauteil erwärmt.

Falls bestimmte integrierte Schaltkreise, die zur Erstellung einer Leiterplatte erforderlich sind, nicht mehr oder zumindest nicht mehr in der vorgesehenen Bauform hergestellt werden, ist es erforderlich die Leiterbahnen der Leiterplatte anzupassen, die zur elektrischen Kontaktierung mit dem bestimmten integrierten Schaltkreis vorgesehen sind. Dies bedingt eine vollständige Änderung des Layouts der Leiterplatte. Das veränderte Layout muss erneut getestet und auf etwaige Fehler überprüft werden, was vergleichsweise kosten- und zeitintensiv ist, insbesondere wenn die Leiterplatte lediglich in vergleichsweise geringer Stückzahl produziert wird.

Der Erfindung liegt die Aufgabe zugrunde, eine besonders geeignete Leiterplattenanordnung mit einer einen SMD-Bestückplatz zur Anbringung eines ersten integrierten Schaltkreises aufweisenden Leiterplatte anzugeben, die insbesondere auch bei einer Nichtverfügbarkeit des ersten integrierten Schaltkreises herstellbar ist, wobei die Herstellung zweckmäßigerweise vergleichsweise zeit- und kostensparend sein soll.

In der US 2002/0093803 A1 ist ist ein Adapter für einen integrierten Schaltkreis offenbart, der in einer alten und in einer neuen Ausführungsform als oberflächenmontiertes Bauelement vorliegt. Bei der alten Ausführung weist das Gehäuse des Schaltkreises 68 Pins und in der neuen Ausführungsform 44 Pins auf. Bei einem Nicht-Vorliegen der alten Ausführungsform wird die neue Ausführungsform auf einer Adapterleiterplatte montiert und die Adapterleiterplatte auf der Leiterplatte, die für die alte Bauform des integrierten Schaltkreises vorgesehen ist. Hierbei liegt die Adapterleiterplatte auf der Leiterplatte auf und ist folglich in direktem mechanischen Kontakt mit dieser.

Aus der DE 10 2006 053 461 A1 ist eine mikroelektronische Baugruppe mit mindestens zwei parallel übereinander angeordneten Schaltungsträgern bekannt. Zwei zueinander benachbarte Schaltungsträger sind mechanisch mittels eines oberflächenmontierten Bauelements verbunden, wobei das oberflächenmontierte Bauelement Bestandteil einer Schaltung zumindest eines der Schaltungsträger ist.

Hinsichtlich der Leiterplattenanordnung wird diese Aufgabe durch die Merkmale des Anspruchs 1 und hinsichtlich einer Austauschleiterplatte durch die Merkmale des Anspruchs 11 erfindungsgemäß gelöst. Vorteilhafte Weiterbildungen und Ausgestaltungen sind Gegenstand der Unteransprüche.

Die Leiterplattenanordnung umfasst eine Leiterplatte, die einen SMD-Bestückplatz aufweist. Der SMD-Bestückplatz umfasst eine Anzahl elektrischer Kontaktstellen, die in einem bestimmten, vorgegebenen Abstand und Winkel zueinander ausgerichtet sind. Die Kontaktstellen selbst sind Bestandteil jeweils einer Leiterbahn, die vorzugsweise mit weiteren elektrischen Bauteilen der Leiterplatte elektrisch kontaktiert sind, wie z.B. Kondensatoren oder Widerständen. Die Anordnung der Kontaktstellen ist hierbei derart, dass ein erster integrierter Schaltkreis mit dem SMD-Bestückplatz elektrisch kontaktierbar ist, wobei die Montage des ersten integrierten Schaltkreises an der Leiterplatte in SMD-Technik erfolgt. Der erste integrierte Schaltkreis weist eine elektrische Schaltung auf. Die elektrische Schaltung erfüllt beim Betrieb der Leiterplatte bestimmte Aufgaben, so dass ein ordnungsgemäßer Betrieb der Leiterplatte ermöglicht ist. Die Leiterplattenanordnung ist insbesondere Bestandteil einer Steuerschaltung eines Elektromotors.

Anstelle des ersten integrierten Schaltkreises ist auf dem SMD-Bestückplatz der Leiterplatte in SMD-Technik eine Austauschleiterplatte aufgelötet. Die Austauschleiterplatte ist folglich ein oberflächenmontiertes Bauelement. Als Befestigungsmethode kommt bevorzugt das BGA-Verfahren (boll grid array) oder ein diesem ähnliches Verfahren zum Einsatz. Folglich weist die Austauschleiterplatte vor der Montage auf der Leiterplatte an der dieser zugewandten Seite eine Kugelgitteranordnung auf, die mit den Kontaktstellen des SMD-Bestückplatzes bei der Montage verlötet werden.

Die Austauschleiterplatte weist die elektrische Schaltung des ersten integrierten Schaltkreises auf. Mit anderen Worten übernimmt die Austauschleiterplatte die Funktionen des ersten integrierten Schaltkreises (IC), so dass bei montierter Austauschleiterplatte kein Unterschied im Betrieb der Leiterplatte im Vergleich zu dem montierten ersten integrierten Schaltkreis feststellbar ist. Beispielsweise ist die elektrische Schaltung zumindest teilweise aus diskreten Bauelementen, wie z. B. Widerständen, Kondensatoren und dergleichen, aufgebaut.

Mittels der Austauschleiterplatte ist es einerseits möglich, die ordnungsgemäß funktionierende Leiterplattenanordnung herzustellen, auch wenn der erste integrierte Schaltkreis nicht mehr oder zumindest in der für den SMD-Bestückplatz geeigneten Ausführung nicht lieferbar, nicht vorhanden oder fehlerhaft ist. Andererseits ist mittels der Montage der Austauschleiterplatte an der Leiterplatte mittels SMD-Technik eine Zeitersparnis im Vergleich zu anderen Bestückungs- oder Montagetechniken gegeben. So ist es beispielsweise ermöglicht, die Leiterplatte lediglich in einem Montageverfahren zu bestücken und zu fertigen, sofern die weiteren etwaigen elektrischen Bauteile der Leiterplatte ebenfalls mittels SMD-Technik montierbar sind.

Insbesondere sind mittels der Austauschleiterplatte auch weitere, zusätzliche Funktionen realisiert, sodass der Funktionsumfang der Austauschleiterplatte im Vergleich zu dem ersten integrierten Schaltkreis erweitert ist. Auf diese Weise ist der Einsatzbereich der Leiterplattenanordnung erweitert und die Funktionalität verbessert.

Die Austauschleiterplatte ist über ein elektronisches Bauteil mit dem SMD-Bestückplatz elektrisch kontaktiert. Die Austauschleiterplatte steht somit nicht in direktem mechanischem Kontakt mit dem SMD-Bestückplatz. Vielmehr ist zwischen diesen das elektronische Bauteil angeordnet. Das elektronische Bauteil ist ein SMD-Bauteil, das zweckmäßigerweise in einem Oberflächenmontageverfahren an der Austauschleiterplatte befestigt ist. Insbesondere ist für jede Kontaktstelle des SMD-Bestückplatzes jeweils ein elektronisches Bauteil vorgesehen. Mit anderen Worten entspricht die Anzahl der elektronischen Bauteile der Anzahl der Kontaktstellen des SMD-Bestückplatzes. Mittels der Verwendung des elektronischen Bauteils ist eine definierte Auflagefläche der Austauschleiterplatte auf dem SMD-Bestückplatz bereitgestellt, wobei aufgrund der Verwendung eines oberflächenmontierten Bauelements die Herstellungskosten und die Herstellungszeit der Austauschleiterplatte vergleichsweise gering sind.

Als elektronisches Bauteil wird ein Kondensator herangezogen. Diese sind vergleichsweise einfach und kostengünstig bereitzustellen beschaffen. Die beiden Elektroden des Kondensators sind kurzgeschlossen, also vergleichsweise niederohmig miteinander elektrisch kontaktiert, wobei im Montagezustand insbesondere eine der beiden Elektroden mit der Austauschleiterplatte und die andere Elektrode mit dem SMD-Bestückplatz elektrisch kontaktiert ist. Auf diese Weise ist eine Beeinflussung der Kapazität des Kondensators auf die elektrische Schaltung der Austauschleiterplatte ausgeschlossen, wobei dennoch eine vergleichsweise einfache Anbringung der Austauschplatte an der Leiterplatte ermöglicht ist.

Zweckmäßigerweise umfasst die Austauschleiterplatte einen zweiten integrierten Schaltkreis, dessen Topologie im Wesentlichen derjenigen des ersten integrierten Schaltkreises entspricht. Mit anderen Worten weist der zweite integrierte Schaltkreis die elektrische Schaltung auf. Auf diese Weise ist eine Fertigung der Austauschleiterplatte vergleichsweise einfach, da zur Erstellung der elektrischen Schaltung lediglich der zweite integrierte Schaltkreis montiert werden muss. In diesem Fall fungiert die Austauschleiterplatte somit nach Art eines Adapters, um eine Anschlussbelegung des zweiten integrierten Schaltkreises zur Montage auf dem SMD-Bestückplatz zu ertüchtigen. Ebenso ist es möglich, dass die Topologie des zweiten integrierten Schaltkreises im Vergleich zu der des ersten integrierten Schaltkreises verkleinert ist.

Geeigneterweise ist der zweite integrierte Schaltkreis auf der der Leiterplatte und somit auch auf der dem SMD-Bestückplatz abgewandten Seite der Austauschleiterplatte angeordnet und insbesondere dort montiert. Mit anderen Worten befindet sich die Austauschleiterplatte zwischen der Leiterplatte und dem zweiten integrierten Schaltkreis. Auf diese Weise ist eine visuelle Kontrolle des zweiten integrierten Schaltkreises auch bei vollständig montierter Leiterplattenanordnung ermöglicht. Ferner wird ein Hitzestau im Bereich des zweiten integrierten Schaltkreises vermieden, der aufgrund einer Isolationswirkung der Austauschleiterplatte von einer etwaigen Hitzeentwicklung auf der Leiterplatte abgeschirmt ist.

Alternativ oder in Kombination hierzu ist der zweite integrierte Schaltkreis ein oberflächenmontiertes Bauelement. Folglich ist der zweite integrierte Schaltkreis selbst in SMD-Technik auf der Austauschleiterplatte montiert. Dies erlaubt eine vergleichsweise platzsparende und kostengünstige Fertigung der Austauschleiterplatte.

Insbesondere weist der zweite integrierte Schaltkreis ein Gehäuse in SO-Bauform (small-outline) auf. Insbesondere erfüllt das Gehäuse die Anforderungen an ein Small-Outline-Package und umfasst ein Rastermaß von 1,27 mm. Bevorzugt liegt der zweite integrierte Schaltkreis in einer SO-Bauform vor. Folglich sind die Abmessungen des zweiten integrierten Schaltkreises vergleichsweise gering, so dass ein Platzbedarf auf der Austauschleiterplatte vergleichsweise gering ist. Vorteilhafterweise entspricht die Abmessung der Austauschleiterplatte im Wesentlichen derjenigen des zweiten integrierten Schaltkreises oder zumindest einer weiteren SO-Bauform. Mittels Anbringung der Austauschleiterplatte auf der Leiterplatte in SMD-Technik ist hierbei eine vergleichsweise stabile und fehlerrobuste Montage ermöglicht, die bei anderen Montageverfahren nicht gegeben ist. Alternativ zu der Verwendung einer SO-Bauform weist das Gehäuse eine TQFP-, PLCC- oder eine anderweitig standardisierte Bauform auf. Auch ist eine alternative Verwendung eines Rastermaßes von 0,5mm vorgesehen.

Vorteilhafterweise ist die Austauschleiterplatte lagig oder besonders bevorzugt zweilagig aufgebaut. Mit anderen Worten handelt es sich bei der Austauschleiterplatte um keine sogenannte Multi-Layer-Platine. Auf diese Weise ist die Austauschleiterplatte vergleichsweise kostengünstig herstellbar und ein Konstruktionsaufwand ist reduziert.

Beispielsweise weist das elektronische Bauteil eine Chip-Bauform auf. Das elektronische Bauteil ist deshalb im Wesentlichen rechteckförmig, was einerseits die Montage erleichtert und andererseits eine Lagerhaltung vereinfacht. Besonders bevorzugt ist die Bauform gleich 01005, 0201, 0402 oder 0603, die sowohl eine vergleichsweise hohe Verbreitung als auch besonders geeignete Abmessungen aufweisen. So sind beispielsweise bei der Bauform 01005 die Länge des elektronischen Bauteils gleich 0,4 mm und die Breite gleich 0,2 mm sowie bei der Bauform 0603 die Länge gleich 1,60 mm und die Breite gleich 0,80 mm.

Zweckmäßigerweise ist die Austauschleiterplatte zumindest abschnittsweise zu der Leiterplatte beabstandet und weist folglich zu dieser einen räumlichen Abstand auf. Insbesondere ist dieser Abstand in einem mittleren Bereich der Austauschleiterplatte gebildet und geeigneterweise zwischen elektronischen Bauteilen vorgesehen, sofern mittels dieser eine elektrische Verbindung zwischen der Austauschleiterplatte und der Leiterplatte hergestellt ist. Dabei beträgt der Abstand vorzugsweise der Ausdehnung des oder der elektronischen Bauteile. Insbesondere ist zwischen der Austauschleiterplatte und der Leiterplatte ein Luftspalt gebildet.

Aufgrund des Abstandes ist einerseits eine Montage vereinfacht. Andererseits ist eine thermische Isolierung der Austauschleiterplatte und deren elektrischen Schaltung gegenüber der Leiterplatte verwirklicht. Zudem wird aufgrund des Abstandes ein elektrischer Kurzschluss zwischen etwaigen Leiterbahnen oder unisolierten Abschnitten der Leiterplatte und der Austauschleiterplatte vermieden. Zweckmäßigerweise ist die Austauschleiterplatte im Wesentlichen parallel zu der Leiterplatte angeordnet, was einen vergleichsweise geringen Platzbedarf der Leiterplattenanordnung bedingt.

Zweckmäßigerweise ist die Austauschleiterplatte aus einem Papiergewebe oder besonders bevorzugt aus einem Glasfasergewebe erstellt, das mit Epoxidharz verstärkt ist. Bevorzugt ist die Austauschleiterplatte nach Art einer sogenannten Lochrasterplatine gefertigt. Mit anderen Worten weist die Austauschleiterplatte im unmontierten Zustand ein mittels einer Anzahl von Löchern erstelltes Raster mit einem Rastermaß von 1,2 mm auf. Die Löcher sind, insbesondere auf der dem SMD-Bestückplatz zugewandten Seite, zur Bildung von Lötaugen mit einem elektrisch leitenden Material umgeben, insbesondere mit Kupfer. Die einzelnen Lötaugen sind vorteilhafterweise gegeneinander elektrisch isoliert, um eine Vielzahl unterschiedlicher elektrischer Schaltungen zu ermöglichen, ohne keinen Kurzschluss oder dergleichen befürchten zu müssen. Aufgrund der Verwendung einer Lochrasterplatine ist zwar die Herstellungszeit der Austauschleiterplatte erhöht. Jedoch ist es nicht erforderlich, spezielle Werkzeuge zur Herstellung der Austauschleiterplatte zu verwenden oder diese entsprechend zu programmieren. Es wird lediglich ein standardisiertes Bauteil verwendet und auf die erforderliche Größe abgelenkt. Somit ist auch bei einer vergleichsweise geringen Stückzahl eine vergleichsweise einfache und schnelle Fertigung der Austauschleiterplatte ermöglicht.

Die Austauschleiterplatte weist eine elektrische Schaltung auf und ist eingerichtet und vorgesehen mittels SMD-Technik, insbesondere in einem BGA-Verfahren oder einem BGA-ähnlichen Verfahren (Kugelgitteranordnung), auf einer Leiterplatte montiert zu werden. Zweckmäßigerweise ist die elektrische Schaltung in einem zweiten integrierten Schaltkreis realisiert, der zweckmäßigerweise in einer SO8-Bauform vorliegt. Auf der dem zweiten integrierten Schaltkreis gegenüberliegenden Seite umfasst die Austauschleiterplatte bevorzugt elektronische Bauteil zur Kontaktierung mit einem SMD-Bestückungsplatz der Leiterplatte.

Nachfolgend werden Ausführungsbeispiele der Erfindung anhand einer Zeichnung näher erläutert. Darin zeigen:
- Fig. 1: perspektivisch eine Leiterplatte mit einem SMD-Bestückplatz;
- Fig. 2: die Leiterplatte mit einem an dem SMD-Bestückplatz angebrachten ersten integrierten Schaltkreis,
- Fig. 3: die Leiterplatte mit einer an dem SMD-Bestückplatz angebrachten Austauschleiterplatte,
- Fig. 4: die Austauschleiterplatte von oben,
- Fig. 5: die unbestückte (einlagige) Austauschleiterplatte von unten,
- Fig. 6: die mit Kondensatoren bestückte Austauschleiterplatte von unten, und
- Fig. 7a-7d: eine weitere Ausführungsform der Austauschleiterplatte.

Einander entsprechende Teile sind in allen Figuren mit den gleichen Bezugszeichen versehen.

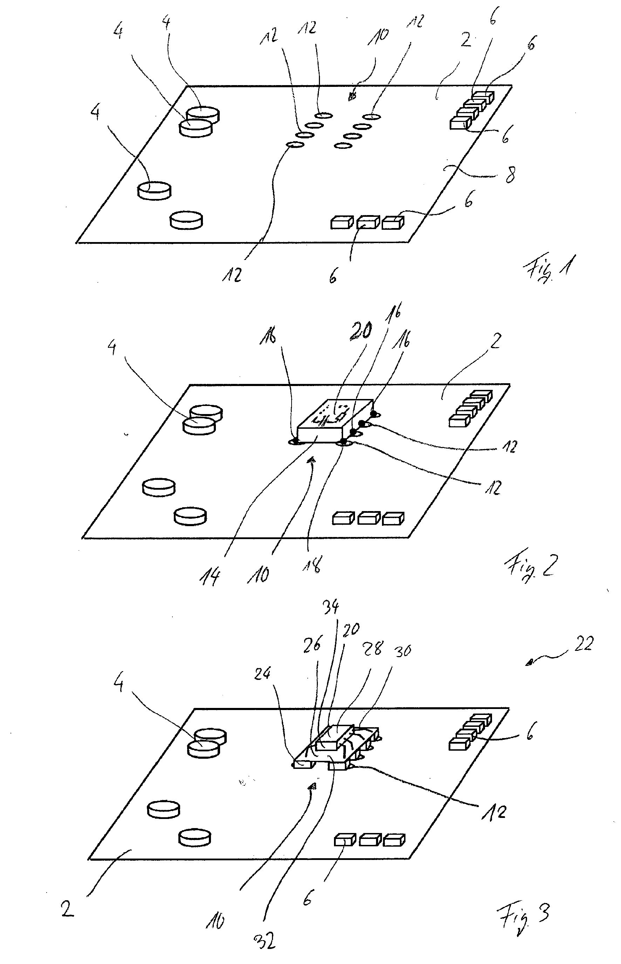

In Fig. 1 ist perspektivisch eine Leiterplatte 2 mit einer Anzahl von Kondensatoren und Widerständen 6 dargestellt, die in SMD-Technik auf einem Leiterplattenkörper 8 aufgebracht sind. Der Leiterplattenkörper 8 besteht aus einem in Epoxidharz getränkten Glasfasergewebe und umfasst nicht näher dargestellte, aus Kupfer gefertigte Leiterbahnen, die die elektrischen Bauteile 4, 6 miteinander elektrisch kontaktieren. Die Leiterplatte 2 umfasst ferner einen SMD-Bestückplatz 10 mit acht Kontaktstellen 12, die aus dem gleichen Material wie die Leiterbahnen gefertigt und mit diesen elektrisch kontaktiert sind.

In Fig. 2 ist die vollständig montierte Leiterplatte 2 dargestellt, bei der ein erster integrierter Schaltkreis (IC) 14 an dem SMD-Bestückplatz 10 angebracht ist. Der erste integrierte Schaltkreis 14 weist eine zu der Anzahl der Kontaktstellen 12 korrespondierende Anzahl von Anschlüssen 16 auf, die in SMD-Technik über eine Lotpaste 18 mit den Kontaktstellen 12 des SMD-Bestückplatzes 10 elektrisch kontaktiert sind. Der erste integrierte Schaltkreis 14 weist eine elektrische Schaltung 20 auf, die auf einem einzelnen Halbleitersubstrat untergebracht ist. Der erste integrierte Schaltkreis 14 nimmt mittels der elektrischen Schaltung 20 solche Aufgaben wahr, die für den Betrieb eines Elektromotors notwendig sind. So wird mittels des ersten integrierten Schaltkreises 14 eine Ansteuerung von Stromventilen eines Umrichters des Elektromotors realisiert.

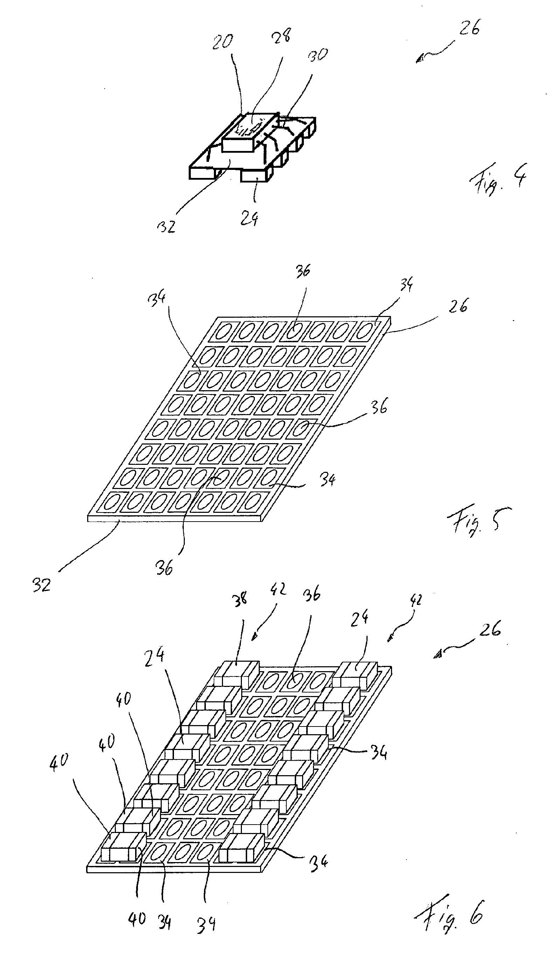

In Fig. 3 ist eine Leiterplattenanordnung 22 dargestellt, die die gleichen Aufgaben wie die in Fig. 2 dargestellte Leiterplatte 2 erfüllt. Diese Leiterplattenanordnung 22 kommt beispielsweise zum Einsatz, falls der erste integrierte Schaltkreis 14 nicht lieferbar ist. Mit dem SMD-Bestückplatz 10 ist in diesem Fall über eine zu der Anzahl der Kontaktstellen 12 korrespondierende Anzahl von elektronischen Bauteilen 24 eine in Fig. 4 näher gezeigte Austauschleiterplatte 26 elektrisch kontaktiert. Hierbei sind sowohl die elektronischen Bauteile 24 an der Austauschleiterplatte 26 als auch die Austauschleiterplatte 26 über die elektronischen Bauteile 24 an dem SMD-Bestückplatz 10 in SMD-Technik angebracht. Infolge dessen ist es ermöglicht, die Austauschleiterplatte 26 in einem Arbeitsschritt mit den Kondensatoren 4 und Widerständen 6 an den Leiterplattenkörper 8 anzulöten.

Mittels der elektronischen Bauteile 24, die auf der der Leiterplatte 2 zugewandten Seite der Austauschleiterplatte 26 angeordnet sind, wird hierbei die Austauschleiterplatte 26 in einem Abstand zu der Leiterplatte 2 gehalten, wobei die Auflagepunkte der Austauschleiterplatte 26 auf der Leiterplatte 2 mittels der elektronischen Bauteile 24 bestimmt sind. Dabei ist die Austauschleiterplatte 26 im Wesentlichen parallel zu der Leiterplatte 2 ausgerichtet. Auf der der Leiterplatte 2 abgewandten Seite der Austauschleiterplatte 26 ist ein zweiter integrierter Schaltkreis 28 mit Anschlüssen 30 angebracht, wobei die Anschlüsse 30 durch einen Austauschleiterplattenkörper 32 mit den elektronischen Bauteilen 24 durchkontaktiert sind. Mit anderen Worten ist jeweils einer der Anschlüsse 30 über ein zugeordnetes elektronisches Bauteil 24 mit jeweils einer der Kontaktstellen 12 des SMD-Bestückplatzes 10 elektrisch verbunden. Die Anschlüsse 30 bestimmen hierbei die Bauform des zweiten integrierten Schaltkreises 28 und sind Bestandteil eines Gehäuses 24, das gemäß SO8-Bauform gefertigt ist. Der zweite integrierte Schaltkreis 28 weist ferner die gleiche elektrische Schaltung 20 auf wie der erste integrierte Schaltkreis 14 gemäß Fig. 2. Lediglich die Anschlusskonfiguration, also die Anordnung der Anschlüsse 16, 30 zwischen den beiden integrierten Schaltkreisen 14, 28 unterscheidet sich. Somit ist auch die in Fig. 3 gezeigte Leiterplattenanordnung 22 Bestandteil einer Steuerschaltung eines Elektromotors.

In Fig. 5 ist die der Leiterplatte 2 zugewandte Seite des unbestückten Austauschleiterplattenkörpers 32 perspektivisch gezeigt. Der Austauschleiterplattenkörper 32 ist eine aus einem in Epoxidharz getränkten Glasfasergewebe hergestellte Lochrasterplatine mit einer Anzahl von gegeneinander isolierten Lötaugen 34, die jeweils ein zentrales Loch 36 aufweisen. Die Löcher 36 sind in einem Raster mit einem Rastermaß von 1,27 mm angeordnet. Die Lötaugen 34 umfassen ein elektrisch leitfähiges Material, wie beispielsweise Kupfer.

In Fig. 6 ist die mit den elektronischen Bauteilen 24 bestückte Austauschleiterplatte 26 gemäß Fig. 5 gezeigt, wobei die Anzahl der elektronischen Bauteile 24 das doppelte der Anzahl der elektronischen Bauteile 24 der in Fig. 3 und Fig. 4 gezeigten Austauschleiterplatten 26 entspricht. Die elektronischen Bauteile 24 sind jeweils ein Kondensator 38, der eine Chip-Bauform aufweist. Die Bauform ist gleich 0603. Folglich weist jeder Kondensator 28 zwei umlaufende Elektroden 40 auf. Die beiden Elektroden 40 jedes Kondensators 38 sind jeweils mit einem der Lötaugen 34 elektrisch kontaktiert, wobei die Lötaugen 34 zueinander benachbart sind. Hierbei sind die oberflächenmontierten Kondensatoren 38 in zwei Reihen 42 angeordnet, die die an gegenüberliegenden Rändern des Austauschleiterplattenkörpers 32 befindlichen Lötaugen 34 überdecken. Hierbei sind im Montagezustand die äußersten - also dem Rand am nächsten gelegenen - Lötaugen 34 über die zugeordnete Elektrode 40 mit der jeweiligen Kontaktstellen 12 des SMD-Bestückplatzes 10 elektrisch kontaktiert und dort angelötet. Durch das jeweilige Loch 36 ist der zweite integrierte Schaltkreis 28 über die Anschlüsse 30 elektrisch kontaktiert. Hierfür sind die jeweiligen Löcher 36 mit Lotpaste zur Durchkontaktierung befüllt.

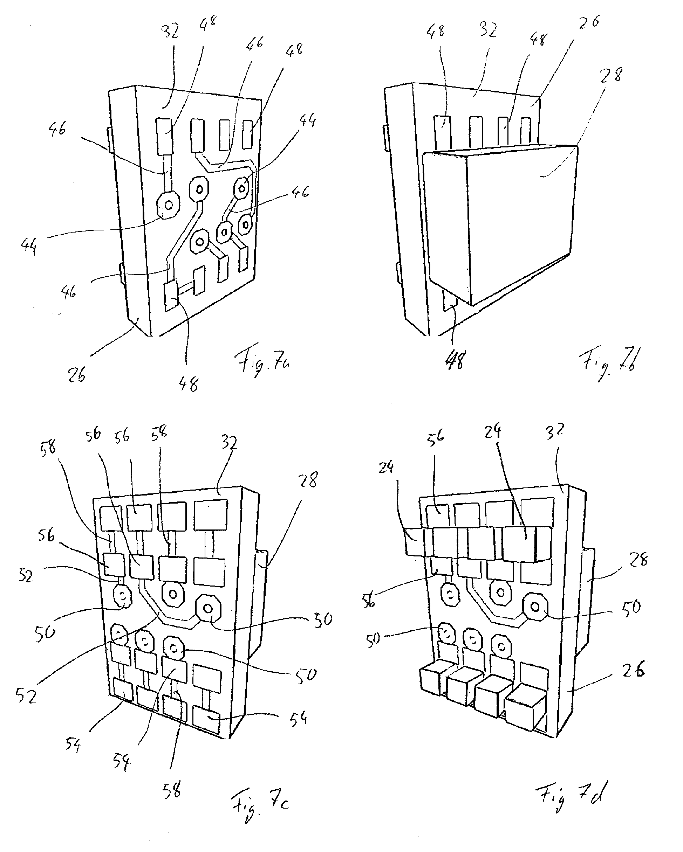

In Fig. 7a ist eine weitere Ausführungsform der Austauschleiterplatte 26 mit einem geänderten Austauschleiterplattenkörper 32 perspektivisch gezeigt. Der in einem Ätz- oder Druckverfahren hergestellte Austauschleiterplattenkörper 32 weist sechs erste Lötaugen 44 auf, die über erste Leiterbahnen 46 miteinander und/oder Befestigungsflächen 48 elektrisch verbunden sind. Im Montagezustand, wie in Fig. 7b dargestellt, ist der zweite integrierte Schaltkreis 28 an den ersten Befestigungsflächen 48 elektrisch leitend mittels SMD-Technik befestigt.

Jedes erste Lötaugen 44 ist mit einem zugeordneten zweiten Lötaugen 50 elektrisch kontaktiert, wobei die zweiten Lötaugen 50 sich auf der dem zweite integrierte Schaltkreis 28 gegenüberliegenden Seite des Austauschleiterplattenkörper 32 befinden. Mit anderen Worten sind die ersten und zweiten Lötaugen 44, 50 durchkontaktiert und der Austauschleiterplattenkörper 32 zweilagig aufgebaut.

Die zweiten Lötaugen 50 selbst sind ferner entweder direkt oder mittels zweiter Leiterbahnen 52 mit zweiten Befestigungsflächen 54 auf der gleichen Austauschleiterplattenkörperseite elektrisch kontaktiert. Jede zweite Befestigungsfläche 54 weist zwei zueinander beabstandete Anlageflächen 56 auf, die aus dem Material der Leiterbahnen 46, 52 gefertigt und über einen Steg 58 aus dem gleichen Material miteinander verbunden sind. An jeder Befestigungsfläche 54 wird das elektronische Bauteil 24 angebracht, wobei das elektronische Bauteil 24 in SMD-Technik an jeder der Anlageflächen 56 der zugeordneten Befestigungsfläche 54 angelötet wird, wie in Fig. 7d gezeigt. Die elektronischen Bauteile 24 sind somit elektrisch parallel zu dem zugeordneten vergleichsweise niederohmigen Steg 58 geschalten. Auf diese Weise ist der Einfluss der elektrischen Eigenschaften der elektronischen Bauteile 24 auf die Arbeitsweise der Austauschleiterplatte 26 vernachlässigbar. Aufgrund der Verwendung der Lötaugen 44, 50 und der zugeordneten Leiterbahnen 46, 52 ist es ermöglicht, einen zweiter integrierter Schaltkreis 28 zu verwenden, dessen Anschlusskonfiguration von der des ersten integrierter Schaltkreis 14 abweicht.

Die Erfindung ist nicht auf die vorstehend beschriebenen Ausführungsbeispiele beschränkt. Vielmehr können auch andere Varianten der Erfindung von dem Fachmann hieraus abgeleitet werden, ohne den Gegenstand der Erfindung zu verlassen. Insbesondere sind ferner alle im Zusammenhang mit den einzelnen Ausführungsbeispielen beschriebene Einzelmerkmale auch auf andere Weise miteinander kombinierbar, ohne den Gegenstand der Erfindung zu verlassen.

### Bezugszeichenliste

- 2: Leiterplatte
- 4: Kondensator
- 6: Widerstand
- 8: Leiterplattenkörper
- 10: SMD-Bestückplatz
- 12: Kontaktstelle
- 14: erster integrierter Schaltkreis
- 16: Anschluss
- 18: Lotpaste
- 20: elektrische Schaltung
- 22: Leiterplattenanordnung
- 24: elektronisches Bauteil
- 26: Austauschleiterplatte
- 28: zweiter integrierter Schaltkreis
- 30: Anschluss
- 32: Austauschleiterplattenkörper
- 34: Lötaugen
- 36: Loch
- 38: Kondensator
- 40: Elektrode
- 42: Reihe
- 44: erstes Lötauge
- 46: erste Leiterbahnen
- 48: erste Befestigungsfläche
- 50: zweites Lötauge
- 52: zweite Leiterbahnen
- 54: zweite Befestigungsfläche
- 56: Anlagefläche
- 58: Steg

## Patentansprüche

1. Leiterplattenanordnung (22) mit einer Leiterplatte (2), die einen SMD-Bestückplatz (10) zur Anbringung eines eine elektrische Schaltung (20) aufweisenden ersten integrierten Schaltkreises (14) aufweist, wobei auf den SMD-Bestückplatz (10) in SMD-Technik eine die elektrische Schaltung (20) aufweisende Austauschleiterplatte (26) aufgelötet ist,
- wobei die Austauschleiterplatte (26) über ein elektronisches Bauteil (24) mit dem SMD-Bestückplatz (10) elektrisch kontaktiert ist,
- wobei das elektronische Bauteil (26), ein oberflächenmontiertes Bauelement ist,
- wobei das elektronische Bauteil (24) ein Kondensator (38) ist, und
- wobei die Elektroden (40) des Kondensators (38) kurzgeschlossen sind.

2. Leiterplattenanordnung (22) nach Anspruch 1,
**dadurch gekennzeichnet,**
**dass** die Austauschleiterplatte (26) einen die elektrische Schaltung (20) aufweisenden zweiten integrierten Schaltkreis (28) umfasst.

3. Leiterplattenanordnung (22) nach Anspruch 2,
**dadurch gekennzeichnet,**
**dass** der zweite integrierte Schaltkreis (28) auf der der Leiterplatte (2) abgewandten Seite der Austauschleiterplatte (26) angeordnet ist.

4. Leiterplattenanordnung (22) nach Anspruch 2 oder 3,
**dadurch gekennzeichnet,**
**dass** der zweite integrierte Schaltkreis (28) ein oberflächenmontiertes Bauelement ist.

5. Leiterplattenanordnung (22) nach einem der Ansprüche 2 bis 4,
**dadurch gekennzeichnet,**
**dass** der zweite integrierte Schaltkreis (28) ein Gehäuse (34) in SO-Bauform aufweist, insbesondere SO8-Bauform

6. Leiterplattenanordnung (22) nach Anspruch 5,
**dadurch gekennzeichnet,**
**dass** das elektronische Bauteil (24) eine Chip-Bauform aufweist, insbesondere 0603, 0402, 0201 oder 01005.

7. Leiterplattenanordnung (22) nach einem der Ansprüche 1 bis 6,
**dadurch gekennzeichnet,**
**dass** die Austauschleiterplatte (26) zumindest abschnittsweise zu der Leiterplatte (2) beabstandet ist, und/oder dass die Austauschleiterplatte (26) parallel zur Leiterplatte (2) ist.

8. Leiterplattenanordnung (22) nach einem der Ansprüche 1 bis 7,
**dadurch gekennzeichnet,**
**dass** die Austauschleiterplatte (26) eine Lochrasterplatine mit einer Anzahl Lötaugen (34) umfasst, die insbesondere gegeneinander elektrisch isoliert sind.
